# EUROPÄISCHE PATENTSCHRIFT

(11) **EP 0 705 149 B1**
(45) Veröffentlichungstag und Bekanntmachung des Hinweises auf die Patenterteilung: **03.06.1998**
(21) Anmeldenummer: 94916150.9
(22) Anmeldetag: 31.05.1994
(51) Int. Cl.: B05D 7/24, C08J 7/00

(54) **VERFAHREN ZUM HERSTELLEN EINER POLYMEREN BESCHICHTUNG AN KUNSTSTOFF-HOHLKÖRPERN**
METHOD FOR PRODUCING A POLYMER COATING INSIDE HOLLOW PLASTIC ARTICLES
PROCEDE D'APPLICATION D'UN REVETEMENT POLYMERE SUR LA SURFACE INTERIEURE DE CORPS CREUX EN MATIERE PLASTIQUE

(30) Priorität: 01.06.1993 DE 4318084; 01.06.1993 DE 4318086
(43) Veröffentlichungstag der Anmeldung: 10.04.1996
(60) Teilanmeldung: 97100404.9
(73) Patentinhaber: Kautex Textron GmbH & Co. KG., 53229 Bonn (DE); Buck Werke GmbH & Co, 73337 Bad Überkingen (DE)
(72) Erfinder: ESSER, Klaus, D-53639 Königswinter (DE); KARSCH, Ulrich, D-53859 Niederkassel (DE); RUNKEL, Jürgen, D-53229 Bonn (DE); GRÜNWALD, Heinrich, D-72810 Gomaringen (DE); NAUENBURG, Klaus, D-72072 Tübingen (DE); WEICHART, Jürgen, D-70794 Filderstadt (DE); DIENER, Christoph, D-72202 Nagold (DE)
(74) Vertreter: Koepsell, Helmut, Dipl.-Ing.
(86) Internationale Anmeldenummer: DE9400622
(87) Internationale Veröffentlichungsnummer: WO9427745

(56) Entgegenhaltungen:
- DE-A- 3 632 748
- DE-A- 3 712 492
- DE-A- 3 908 418
- GB-A- 2 053 026
- US-A- 4 536 271
- US-A- 4 656 083

## Beschreibung

Die Erfindung betrifft ein verfahren zum Herstellen einer polymeren Beschichtung auf wenigstens einem Teilbereich der inneren Oberfläche eines wenigstens teilweise aus Kunststoff bestehenden Hohlkörpers unter Anwendung der Niederdruck-Plasmapolymerisation gemäß dem Oberbegriffes des Anspruches 1

Bei einem durch die DE-PS 3,632,748 bekannten derartigen Verfahren zur Bildung diffusionshemmender Schichten mittels Plasmapolymerisation von nicht näher bezeichneten Monomeren erfolgt die Plasmaanregung durch von außen eingekoppelte Mikrowellen. Ein auf diese Weise angeregtes Plasma wird für Hohlkörper kleineren Volumens geeignet sein. Bei Hohlkörpern größeren Volumens ist jedoch ein mittels Mikrowellen angeregtes Plasma nur bei Anwendung zusätzlicher Maßnahmen so gleichmäßig, wie es zur Erzeugung einer Deckschicht erforderlich ist, die auch bei größerer Flächenausdehnung, wie sie bei einem Hohlkörper größeren Volumens, beispielsweise einem Kfz.-Tank gegeben ist, die erforderliche Gleichmäßigkeit aufweist.

An anderer Stelle wird berichtet, daß eine polymere Deckschicht, die durch Mikrowellen-Plasmapolymerisation von Äthylen bzw. Äthylen/Argonmischungen auf einem Kraftstoffbehälter aufgebracht wurde, die Permeation von methanolfreiem Prüfkraftstoff durch Hochdruck-Polyäthylen (HDPE) auf ca. 2% des ursprünglichen Wertes vermindert. Dabei wird der Schluß gezogen, daß sich eine Verbesserung speziell mit einer Plasmaanregung durch Mikrowellen, nicht aber durch Wechselfrequenz im MHz-Bereich erzielen läßt (R. Ludwig, "Plasmapolymerisation - Ein Verfahren zur Erzeugung dünner Schichten", Dissertation an der RWTH Aachen, 1989).

In DE-OS 3,908,418 wird die Plasmapolymerisation von polaren Barriereschichten unter Anwendung eines Plasmas beschrieben, das durch Wechselspannungen im MHz-Bereich angeregt wird. Dabei enthält das Plasma eine unter den jeweiligen Plasmabedingungen polymerisierbare und mit ausreichender Geschwindigkeit überwiegend kettenbildende Komponente. Nachteilig ist, daß polare Barriereschichten eine abstoßende Wirkung auf unpolare Bestandteile von Kraftstoffen, nicht jedoch in Bezug auf Methanol ausüben, so daß die erzielbare Barrierewirkung bei methanolhaltigen Kraftstoffen nicht ausreicht.

Der Erfindung liegt die Aufgabe zugrunde, ein Verfahren gemäß dem Oberbegriff des Anspruches 1, der den Offenbarungsgehalt von DE-OS 3,908,418 berücksichtigt, verfügbar zu machen, welches die wirtschaftliche Herstellung wenigstens einer großflächigen polymeren Deckschicht auf einem Kunststoffsubstrat, insbesondere einem Kunststoffhohlkörper, ermöglicht, wobei die Deckschicht trotz ihrer großflächigen Ausdehnung möglichst einheitliche Eigenschaften aufweisen und somit eine ausreichende Barrierewirkung erzielen soll. Dies soll auch bei einem methanolhaltigen Füllgut, beispielsweise methanolhaltigem Kraftstoff, der Fall sein. Die Deckschicht soll eine Barrierewirkung gewährleisten, die den heutigen und ggf. in Zukunft zu erwartenden Anforderungen an die Undurchlässigkeit derartiger Hohlkörper für das Füllgut genügt. Ferner wird aus wirtschaftlichen Gründen angestrebt, die wenigstens eine Deckschicht in möglichst kurzer Zeilt herzustellen.

Als schichtbildende Komponenten können dabei Verbindungen eingesetzt werden, die unter Plasmabedingungen relativ schnell eine polymere Deckschicht bilden. Dazu gehören beispielsweise Olefine, z. B. Ethylen, gespannte Zykloalkane, z. B. Zyklopropan, Aromaten, Heteroaromaten, z. B. Pyrrol oder Thiophen. Im allgemeinen gilt dabei jedoch, daß mit zunehmender Geschwindigkeit der Schichtbildung der Vernetzungsgrad abnimmt, also überwiegend Ketten gebildet werden.

Da mit abnehmendem Vernetzungsgrad im allgemeinen auch die Sperrwirkung abnimmt, ist es vorteilhaft, neben dem Reaktionsgas, welches die überwiegend kettenbildende Komponente enthält, eine zusätzliche Komponente darstellende Moleküle in der das Plasma bildenden Gasatmosphäre vorzusehen, die unter Plasmabedingungen innerhalb der sich bildenden polymeren Deckschicht überwiegend Verzweigungsstellen in den Polymerketten, insbesondere Vernetzungsstellen zwischen Polymerketten, erzeugen. Dafür haben sich hoch ungesättigte Kohlenwasserstoffverbindungen, z. B. Acetylene oder Allene oder Verbindungen, die unter Plasmabedingungen solche hochgesättigten Kohlenstoff-Verbindungen bilden, z. B. Cyclobuten, als besonders geeignet erwiesen.

Die Verzweigungs- bzw. Vernetzungsstellen ausbildende Komponente kann zusätzlich zu der überwiegend kettenbildenden Komponente in die das Plasma bildende Gasatmosphäre eingeführt werden. Es besteht aber auch die Möglichkeit, daß beide schichtbildenden Komponenten als Strukturelemente desselben Moleküls in das Plasma eingeführt werden, wobei die Moleküle dieser Ausgangssubstanz unter den Bedingungen des Plasmas in Strukturen gespalten werden, die die beiden genannten Komponenten bilden.

Dabei ist die Relation zwischen den beiden Komponenten, also der überwiegend kettenbildenden Komponente und der überwiegend Verzweigungs- bzw. Vernetzungstellen ausbildenden Komponente, so zu wählen, daß die sich aus diesen Komponenten bildende Deckschicht noch keine merkliche Versprödung erfährt, die dazu führen könnte, daß die Deckschicht bezüglich ihrer elastischen Verformbarkeit wesentlich andere Eigenschaften aufweist als die sie tragende eigentliche Wandung des Hohlkörpers, die, da sie aus thermoplastischem Kunststoff besteht, unter der Einwirkung von mechanischen Beanspruchungen relativ leicht elastisch verformbar ist. Bei einer aufgrund der Vernetzung stark versprödeten Deckschicht würde die Gefahr bestehen, daß diese unter der Einwirkung von mechanischen Beanspruchungen und durch diese verursachte Verformungen des Hohlkörpers sich von der Wandung desselben löst und/oder Risse bildet. Das optimale Ausmaß der Vernetzung, bei dem einerseits in kurzer Zeit eine Deckschicht mit der gewünschten Undurchlässigkeit entsteht, andererseits jedoch die Versprödung noch nicht zu einer merklichen Veränderung der mechanischen Eigenschaften dieser Deckschicht führt, kann durch einfache Versuche festgestellt werden.

Die Geschwindigkeit der Bildung der Deckschicht hängt im allgemeinen auch ab von der Menge der pro Zeiteinheit dem Plasma zugeführten polymerisierbaren Substanzen, wobei mit zunehmender Menge pro Zeiteinheit auch die Geschwindigkeit, mit welcher die Deckschicht gebildet wird, zunimmt. Allerdings werden hierbei im allgemeinen gewisse Grenzen einzuhalten sein, da es sonst zur Bildung eines staubigen Niederschlages auf der Substratoberfläche bzw. der sich bildenden Deckschicht kommen kann. Die Bildung von derartigen Staubpartikeln ist insbesondere darauf zurückzuführen, daß Teile der schichtbildenden Komponenten bereits vor Erreichen der Oberfläche des Substrates bzw. der sich bildenden Deckschicht "kondensieren", also von der gas- oder dampfförmigen Phase in die flüssige und schließlich in die feste Phase übergehen. Der Nachteil der Bildung derartiger Staubpartikel besteht darin, daß sie sich auf der Oberfläche des Substrates bzw. der sich bildenden Deckschicht absetzen mit der Folge, daß sich an diesen Stellen keine porenfreie Deckschicht bildet und nach späterem Ablösen der Staubpartikel von der Oberfläche an diesen Stellen die Beschichtigung nicht die notwendige Undurchlässigkeit aufweist. Außerdem ist die Bildung von Staub innerhalb von Behältern, insbesondere von Kraftstoffbehältern, generell unerwünscht.

Es kann somit bei Vorliegen bestimmter Betriebsbedingungen zweckmäßig sein, der in das Plasma einzuführenden Ausgangssubstanz noch eine der Bildung von Staub entgegenwirkende Komponente hinzuzufügen. Dabei kann es sich um inerte Gase oder Dämpfe handeln, die das Reaktionsgas verdünnen, so daß die Polymerisation in der Gasphase verlangsamt wird. Dies wird allerdings nur dann zweckmäßig sein, wenn dadurch die Geschwindigkeit, mit welcher die Deckschicht gebildet wird, die Wirtschaftlichkeit des Verfahrens nicht beeinträchtigt. Eine Vermeidung oder zumindest Verringerung der Staubbildung kann aber auch dadurch erreicht werden, daß als Staubverhinderer solche Substanzen hinzugefügt werden, die im Plasma reaktive Teilchen, z. B. Monoradikale bilden, die die Entstehung großer Aggregate in der Gasphase hemmen. Derartige die Staubbildung hemmende Substanzen wirken im wesentlichen in der Weise, daß einige der Valenzen der schichtbildenden Komponenten gesättigt werden, wodurch die Teilchen der letzteren weniger reaktiv sind. Dadurch wird erreicht, daß die Polymerisation zumindest überwiegend erst auf der Oberfläche des Substrats bzw. der in der Bildung befindlichen Deckschicht erfolgt, so daß eine bereits in der Gasphase stattfindende Polymerisation, die letzten Endes, abgesehen von der möglichen Porenbildung, die Effizienz der Schichtbildung herabsetzt, weitestgehend vermieden wird.

Als inerter Staubverhinderer, die die Konzentration der polymerisierenden Teilchen verringern, können Argon oder Helium eingesetzt werden. Als Bildner von reaktiven Teilchen, deren Reaktion mit den schichtbildenden Komponenten hingegen die Geschwindigkeit der Bildung der Abdeckschicht kaum verringert, kommen H₂, CH₄, N₂, NH₃, Ethan und andere niedere Alkane in Frage.

Als hochfrequente elektromagnetische Energie zur Erzeugung des Plasmas kann eine Radiofrequenz verwendet werden. Diese hat einmal den Vorteil, daß die zur Erzeugung des Plasmas erforderliche Energie merklich geringer ist als im Falle der Plasmaerzeugung durch Mikrowellen. Dadurch ist das durch Radiofrequenz erzeugte Plasma weniger "scharf", welche Tatsache - unabhängig von der Menge der zugeführten schichtbildenden Komponenten - zu einem langsameren Reaktionsablauf führt mit der Folge, daß die durch Plasmapolymerisation aufgebrachte Deckschicht - bei sonst gleichen Bedingungen - eine bessere Qualität als bei Verwendung von Mikrowellen aufweist. Ein weiterer Vorteil kann darin bestehen, daß in einem durch Radiofrequenz angeregten Plasma die negativ geladenen Elementarteilchen, die Elektronen, einen größeren Bewegungsbereich aufweisen mit der Folge, daß aufgrund der dadurch bedingten Ausbildung der Randschichten des Plasmas Bedingungen für die Bildung der Deckschicht durch Polymerisation vorhanden sind, die bei Anwendung von Mikrowellen nicht erreicht werden können.

Es ist aber auch möglich, das Plasma durch Anwendung von Mikrowellen zu erzeugen. Ferner besteht die Möglichkeit, das Plasma innerhalb des Hohlkörpers durch gleichzeitige Anwendung sowohl von Radiofrequenz als auch von Mikrowellen zu erzeugen. Dadurch würde neben den bereits erwähnten Vorteilen bei der Anwendung der Radiofrequenz zur Erzeugung des Plasmas auch der den Mikrowellen eigene Vorteil nutzbar gemacht werden, der insbesondere in einer höheren Abscheiderate aus dem Plasma und damit in einer kürzeren Prozeßzeit, d.h., einer höheren Produktivität des Verfahrens, besteht.

Um die Durchlässigkeit der Deckschicht für Alkohol, insbesondere Methanol, zu minimieren, sollten die die Deckschicht bildenden Substanzen möglichst unpolar sein. Dazu werden im wesentlichen unpolare Ausgangssubstanzen verwendet, da letztere diese Eigenschaft auch bei ihrer Polymerisation nicht verlieren und somit eine Deckschicht aus zumindest überwiegend unpolaren Substanzen bilden. Bei den Ausgangssubstanzen kann es sich erfindungsgemäß z.B. um gas- oder dampfförmige Kohlenstoff- und Siliziumverbindungen handeln, die die Bildung hochvernetzter Polymerschichten erwarten lassen und zu einer permeationsdichten Barriereschicht führen. Geeignete unpolare Ausgangssubstanzen sind z.B. Kohlenwasserstoffe oder Siloxane.

In der Zeichnung sind einige Ausführungsbeispiele im Schema dargestellt. Es zeigen:
- Fig. 1: eine erste Ausführungsform einer Einrichtung zum Aufbringen einer polymeren Deckschicht auf der inneren Oberfläche eines Hohlkörpers aus Kunststoff unter Verwendung von Radiofrequenz zur Erzeugung des Plasmas
- Fig. 2: eine der Fig. 1 entsprechende Darstellung einer zweiten Ausführungsform,
- Fig. 3: die Darstellung einer dritten Ausführungsform,
- Fig. 4: eine Einrichtung zum gleichzeitigen Behandeln mehrerer Hohlkörper,
- Fig. 5: eine Einzelheit in größerem Maßstab.
- Fig. 6: eine der Fig. 1 entsprechende Darstellung einer dritten Ausführungsform,
- Fig. 7: eine vierte Ausführungsform, bei welcher das Plasma unter Verwendung von Mikrowellen erzeugt wird.

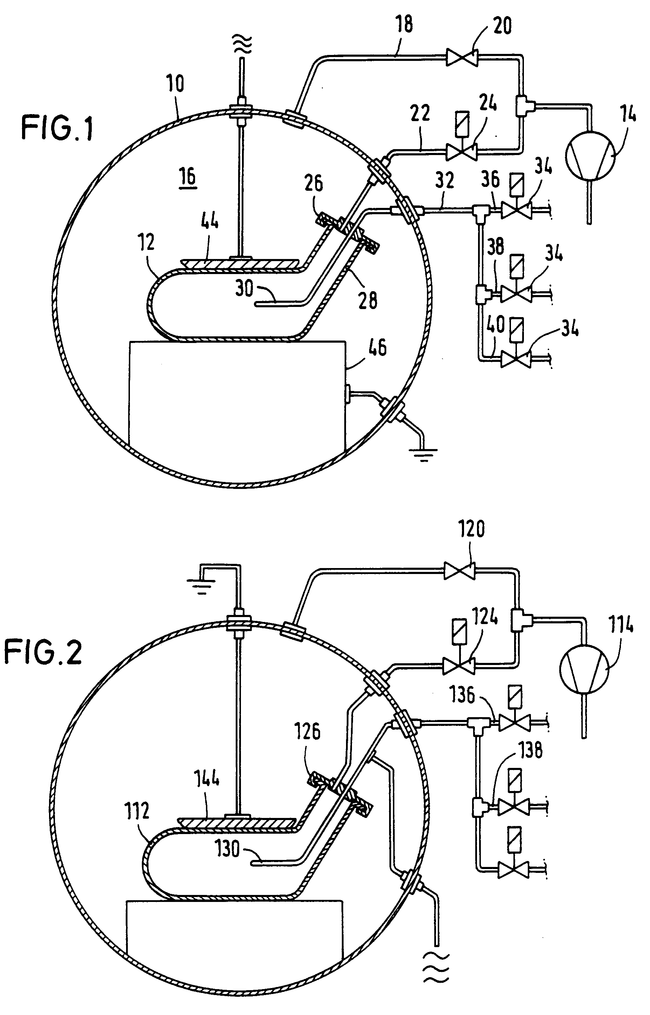

Beim Ausführungsbeispiel gemäß Fig. 1 ist eine Vakuumkammer 10 vorhanden, innerhalb derer Kraftstoff-Tanks aus thermoplastischem Kunststoff mit einer Innenbeschichtung in Form einer polymeren Deckschicht zu versehen sind. In Abhängigkeit von der Größe des jeweils zu behandelnden Tanks 12 kann die Vakuumkammer ein Volumen von beispielsweise 300 l aufweisen. Sie ist vorzugsweise an einer ihrer Stirnseiten mit einer verschließbaren Öffnung versehen, durch die der jeweils mit der Beschichtung zu versehende Tank 12 in die Vakuumkammer 10 eingebracht werden kann. Letztere wird anschließend verschlossen und danach gemeinsam mit dem Tank 12 durch eine Vakuumpump-Einrichtung 14 evakuiert. Die Verbindung zwischen Vakuumpump-Einrichtung 14 und dem Innenraum 16 der Vakuumkammer 10 wird über eine Leitung 18 hergestellt, die mit einem Ventil 20 versehen ist.

Das Innere des Tanks 12 ist über eine Leitung 22 mit der Vakuumpump-Einrichtung 14 verbunden. In der Leitung 22 ist ein Ventil 24 angeordnet. Die Öffnung des Tankes 12, durch welche die Evakuierung erfolgt, ist durch einen lösbaren Schnellverschluß 26 in Form einer Kappe oder dgl. verschlossen, die mittels beispielsweise eines Bajonettverschlusses am Stutzen 28 des Tanks angebracht werden kann. Die Leitung 22 für die Evakuierung des Tanks 12 ist mit einer Öffnung in diesem Deckel dicht verbunden. Eventuell weitere noch am Tank 12 vorhandene Öffnungen, die beispielsweise herstellungsbedingt sein können, sind zuvor verschlossen worden. Es kann aber auch zweckmäßig sein, solche weiteren Öffnungen, die bei Verwendung des Tanks beispielsweise in einem Kfz. erforderlich sind, nach der Beschichtung mittels Plasmapolymerisation anzubringen.

Innerhalb des Tankes 12 ist in der üblichen Weise eine Sonde 30 angeordnet, die der Zuführung der Ausgangssubstanz(en) zur Bildung der polymeren Deckschicht dient. Die Sonde 30 ist ebenfalls mit der Kappe oder dgl. des Schnellverschlusses 26 dicht verbunden, die dazu mit einer weiteren Öffnung versehen ist, an welcher eine Zuleitung 32 angeschlossen ist. Die Zuleitung 32 stellt eine Sammelleitung dar, in welche unter Zwischenschaltung jeweils eines Absperrorgans 34 Leitungen 36, 38, 40 münden, die jeweils mit nicht dargestellten Vorratsbehältern oder dgl. für mindestens eine Ausgangssubstanz und ggf. weitere Substanzen(en) verbunden sind. So kann beispielsweise über die Leitung 36 die Ausgangssubstanz für die überwiegend kettenbildende Komponente zugeführt werden. Die Leitung 38 kann der Zuführung der Ausgangssubstanz(en) für die überwiegend die Verzweigungs- bzw. Vernetzungsstellen ausbildende Komponente dienen. Über die Leitung 40 kann die Komponente zugeführt werden, die die Staubbildung innerhalb des Tankes 12 hemmt.

Die Evakuierung des Innenraums 16 der Vakuumkammer 10 und des Tanks 12 erfolgt zunächst gemeinsam. Bei Erreichen eines Druckes von ca. 1000 Pa wird das Ventil 20 geschlossen, so daß der Druck innerhalb des Raumes 16 nicht unter 1000 Pa fällt. Das Innere des Tanks 12 wird weiter bis zu einem Druck von ca. 1 Pa evakuiert. Anschließend wird über Leitung 32 und Sonde ein Gasgemisch aus z. B. 50% Ethylen, 30% Acetylen und 20% Methan in den Tank 12 geben. Mit Hilfe des Drosselventils 24 wird bei laufender Pumpe ein Druck von 6 Pa eingestellt. Die Durchflußraten für die vorgenannten Gase betragen jeweils 25 bzw. 15 bzw. 10 cm³/min, d. h., daß der größte Anteil im Gasgemisch auf die überwiegend kettenbildende und der geringste Anteil auf die Staub hemmende Komponente entfällt.

Danach wird eine innerhalb der Vakuumkammer in einem geringen Abstand vom Tank 12 oberhalb desselben angeordnete Flächenelektrode 44 an eine Hochfrequenzspannung von 13,56 MHz mit einer Leistung von 100 W angelegt. Dies führt zur Zündung eines Plasmas innerhalb des Tankes 12, welches während etwa 30 min aufrechterhalten wird. Außerhalb des Tanks 12 im Innenraum 16 entsteht kein Plasma, da dazu der Druck im Innenraum 16 zu hoch ist. Außerdem wirkt die Positionierung der Elektrode 44 der Zündung eines Plasmas im Innenraum 16 entgegen. Der Tank 12 liegt innerhalb der Vakuumkamer 10 auf einer geerdeten Auflage 46, die die zweite Elektrode darstellt.

Während des Beschichtungsvorganges wird das Plasma mit einem optischen Sensor, der die Helligkeit des Plasmas integral im Wellenbereich von 300 bis 900 nm detektiert, beobachtet. Diese Maßnahme dient insbesondere der Konstanthaltung des Plasmas, um so die Bildung einer Deckschicht mit reprodzierbaren Eigenschaften zu erhalten.

Anschließend wird die Hochfrequenzspannung abgeschaltet, der Gaszufluß unterbrochen und erneut auf 1 Pa evakuiert. Nach Beendigung des Evakuierens werden Kammer 10 und Tank 12 belüftet. Schnellverschluß 26 und Sonde 30 werden entfernt. Auf der gesamten Innenfläche des Tanks 12 hat sich eine dichte Schicht mit einer Dicke von 0,1 bis 0,4 µm gebildet, die die Durchlässigkeit der Wandung des Tankes 12 für einen Testkraftstoff, der aus 85% n-Pentan und 15% Methanol besteht nach ECE 34 auf 0,4 g/d vermindert. Bei unbehandelten Tanks beträgt die Durchlässigkeit etwa 20 g/d.

Das Ausführungsbeispiel gemäß Fig. 2 stimmt in wesentlichen Teilen mit dem gemäß Fig. 1 überein, so daß gleiche Teile mit gleichen, jedoch um 100 höheren Bezugszeichen versehen sind. Der wesentliche Unterschied besteht darin, daß bei der Einrichtung gemäß Fig. 2 die innerhalb des Tanks 112 angeordnete Sonde 130 als Elektrode dient, an welcher eine Wechselspannung von 125 KHz und mit einer Leistung von 150 W angelegt wird. Die auch hier verwendete Flächenelektrode 144 ist geerdet. Die Konstanz des sich innerhalb des Tankes 112 ausbildenden Plasmas wird mit einer speziellen Ionenstrom- oder einer LangmuirSonde, die an der Sonde 130 angebracht ist, überwacht. Das Reaktionsgas besteht in diesem Fall aus 50% Ethylen und 50% Acethylen. Es wurde festgestellt, daß bei diesen Betriebsbedingungen auf die Zuführung einer staubhemmenden Komponente verzichtet werden kann. D. h., daß die Ausgangssubstanzen in diesem Fall lediglich über die Leitungen 136, 138 zugeführt werden.

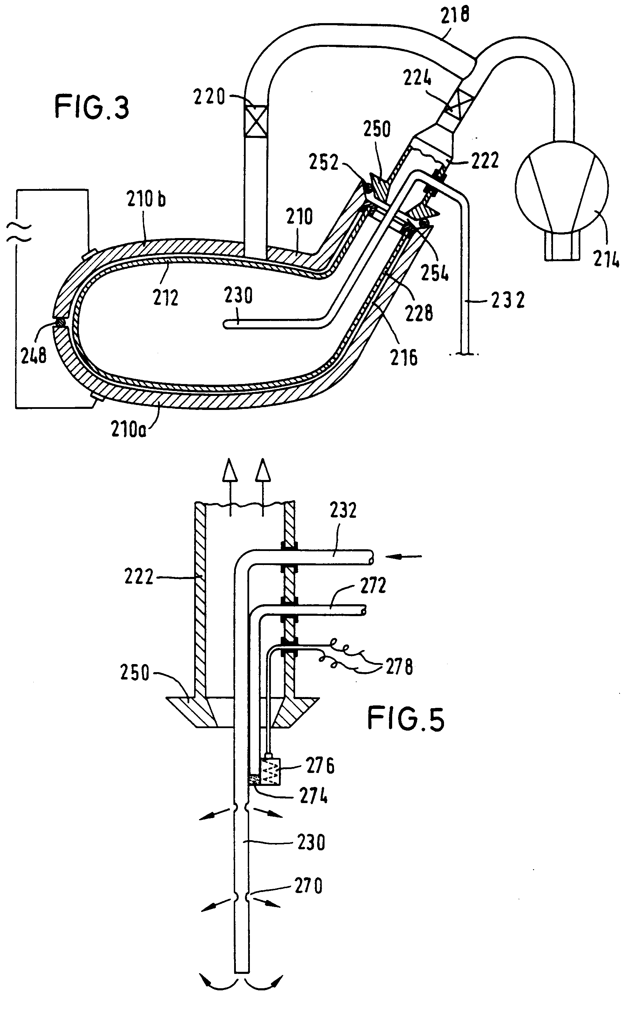

In der Ausführungsform gemäß Fig. 3 sind ebenfalls jene Teile, die denen des Ausführungsbeispiels gemäß Fig. 1 entsprechen, mit gleichen, jedoch um 200 höheren Bezugszeichen versehen. Der wesentliche Vorteil des Ausführungsbeispiels gemäß Fig. 3 besteht in der Verwendung einer Vakuumkammer 210, deren Wandung weitgehend an die Gestalt des in der Vakuumkammer zu behandelnden Kunststofftankes 212 angepaßt ist. D.h., daß die innere Begrenzung der Vakuumkammer 210 im wesentlichen der äußeren Begrenzung des Tankes 212 entspricht. Ein wesentlicher Vorteil dieser Anordnung besteht in dem geringen Volumen des vom Tank 212 nicht ausgefüllten Innenraums 216 der Vakuumkammer, wodurch die für die Evakuierung dieses Innenraumes 216 erforderliche Zeit erheblich reduziert und die Übertragung der Radiofrequenzspannung in das Innere des Tankes 212 optimiert wird. Dies führt zu einer merklichen Verkürzung der für das Aufbringen einer Beschichtung mit bestimmten Qualitäten erforderlichen Behandlungsdauer im Vergleich zu den Ausführungsbeispielen gemäß Fig. 1 und 2. Insgesamt wird auch der Investitionsaufwand für die Einrichtung reduziert.

Zur Erleichterung der Handhabung der Einrichtung ist die Vakuumkammer 210 etwa hälftig unterteilt derart, daß eine untere Hälfte 210a und eine obere Hälfte 210b entstehen, von denen die obere Hälfte 210b als Deckel ausgebildet ist, der von der unteren, stationären Hälfte 210a abgenommen werden kann. Die beiden Teile 210a, 210b sind durch eine Dichtung 248 aus gummielastischem Material gegeneinander elektrisch isoliert. Diese Dichtung bewirkt in geschlossenem Zustand der Kammer 210 zugleich deren Abdichtung gegenüber der Außenatmosphäre.

Von der Vakuumpumpeinrichtung 214 geht eine Leitung 218 für die Evakuierung der Vakuumkammer 210 ab. Die andere Saugleitung 222 ist so ausgebildet und angeordnet, daß sie mit einem an ihrem Endbereich angebrachten Flansch 250, der konisch ausgebildet ist, unter Zwischenschaltung eines Dichtringes 252, an dem eine Öffnung 254 der Vakuumkammer 210 begrenzenden Wandteil der Kammer anliegt, so daß die Öffnung 254 durch den Flansch 250 der Saugleitung 222 verschlossen wird. Die Öffnung des Tanks 212 ist auch hier durch die Kappe eines Schnellverschlusses 226 verschlossen, der mit einer zusätzlichen Öffnung für das Vakuum versehen ist. Die Anordnung kann aber auch so getroffen sein, daß die Saugleitung 222 mit ihrem freien Ende in den Stutzen 228 des Tanks 212 eingreift und diesen dabei nach außen abdichtet. Dazu könnte die Saugleitung mit einem Abschnitt kleineren Durchmesser versehen sein, der über den Flansch 250 in Richtung auf den Tank vorsteht.

Auch hier ist eine innerhalb des Tankes 212 angeordnete Sonde 230 vorgesehen, durch die die für die Bildung der polymeren Deckschicht erforderlichen Substanzen und ggf. auch die die Bildung von Staub hemmende Komponente eingeführt werden. Der Sonde können darüberhinaus auch die anderen Einrichtungen für Überwachung des Plasmas usw. zugeordnet sein. Saugleitung 222 und Sonde 230 sowie weitere zugeordnete Teile können so angeordnet sein, daß beim Einlegen des Tanks 212 in die Vakuumkammer Saugleitung 222 und Sonde 230 mit zugeordneten Teilen zwangsläufig in die richtige Lage zum Tank 212 gebracht werden, bei welcher eine gute Verteilung der Substanzen zur Bildung der Deckschicht im Hohlkörper erreicht wird. Beim Schließen der Vakuumkammer 210 durch entsprechende Positionierung der oberen Hälfte 210b erfolgt dann die endgültige Abdichtung der Vakuumkammer gegen die Außenatmosphäre und die Abdichtung des in der Kammer 210 befindlichen Tanks 212 gegenüber dem Innenraum 216 der Vakuumkammer.

Zur Erzeugung des Plasmas kann eine Radiofrequenz im Bereich von 30 bis ca. 500 kHz bzw. 6,78, 13,56, 27,12 oder 40,68 MHz angelegt werden. Fig. 3 zeigt eine Ausführungsform, bei welcher die Radiofrequenz potentialfrei kapazitiv an beiden Teilen 210a, 210b angelegt ist. Es besteht aber auch die Möglichkeit, analog der Ausführungsform gemäß Fig. 2 die Sonde 230 als Elektrode zu verwenden, wobei beide Hälften 210a, 210b geerdet sind. Eine andere Möglichkeit besteht darin, die Radiofrequenz an eine der beiden Hälften 210a, 210b anzulegen und die jeweils andere Hälfte zu erden.

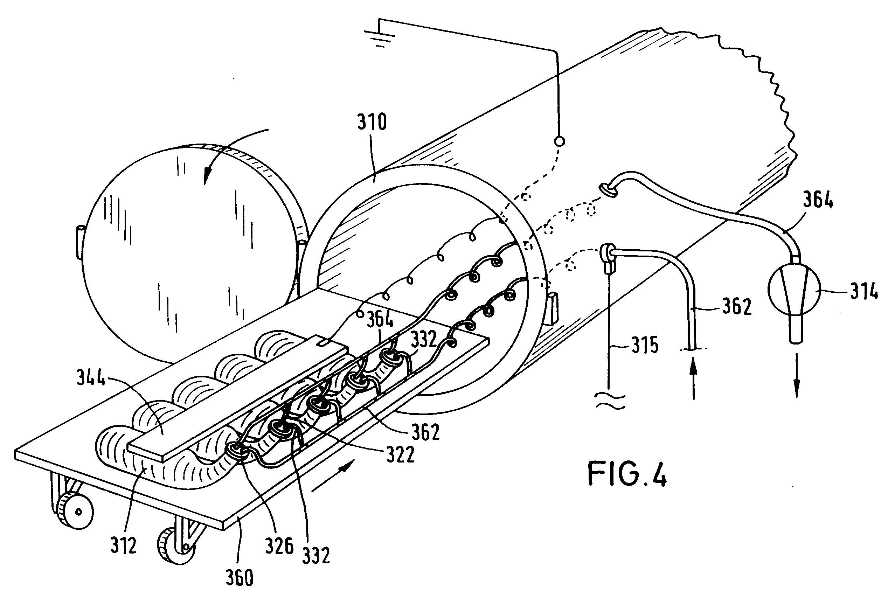

Das Ausführungsbeispiel gemäß Fig. 4, in welcher dem Ausführungsbeispiel gemäß Fig. 1 entsprechende Teile mit gleichen, jedoch um 300 höheren Bezugszeichen versehen sind, ist mit einer Vakuumkammer 310 versehen, die so groß ist, daß sie die gleichzeitige Behandlung mehrerer, z.B. zehn auf einem Beschickungswagen 360 angeordneter Tanks 312 ermöglicht. Dabei ist in Übereinstimmung mit dem Ausführungsbeispiel gemäß Fig. 2 eine oberhalb der Gesamtheit aller Tanks 312 angeordnete Flächenelektrode 344 vorgesehen, die entsprechend dimensioniert und geerdet ist. In jeden der Tanks 312 wird eine Sonde eingeführt. Die einzelnen Tanks 312 sind in der bereits im Zusammenhang mit den Figuren 1 und 2 beschriebenen Weise mit einem Schnellverschluß 326 versehen, der die Sonde trägt und gleichzeitig auch mit einem Durchlaß für die Ausgangssubstanz(en) für die polymere Deckschicht versehen ist. Die Zuleitungen 332 sämtlicher Tanks 312 sind an eine gemeinsame Versorungsleitung 362 angeschlossen, die wiederum in geeigneter Weise mit Vorratsbehältern für die einzelnen Komponenten verbunden ist, wie dies im Zusammenhang mit Figur 1 beschrieben wird. Ferner sind die Saugleitungen 322 sämtlicher Tanks 312 an eine gemeinsame zentrale Saugleitung 364 angeschlossen. Über die elektrische Leitung 315 wird die Wechselspannung an die Sonden 330 angelegt. Diese Wechselspannung kann z.B. 13.56 MHz betragen.

Die zu behandelnden Tanks 312 können außerhalb der Vakuumkammer 310 auf den Beschickungswagen 360 gelegt werden, der dann in die Vakuumkammer 310 eingefahren wird. Über eine Schnellkupplung ggf. auch über eine gemeinsame Schnellkupplung für alle Leitungen, können dann die Verbindungen für die Gaszufuhrleitungen und die Leitung zum Evakuieren der einzelnen Tanks 312 und für den Anschluß der Wechselspannung hergestellt werden.

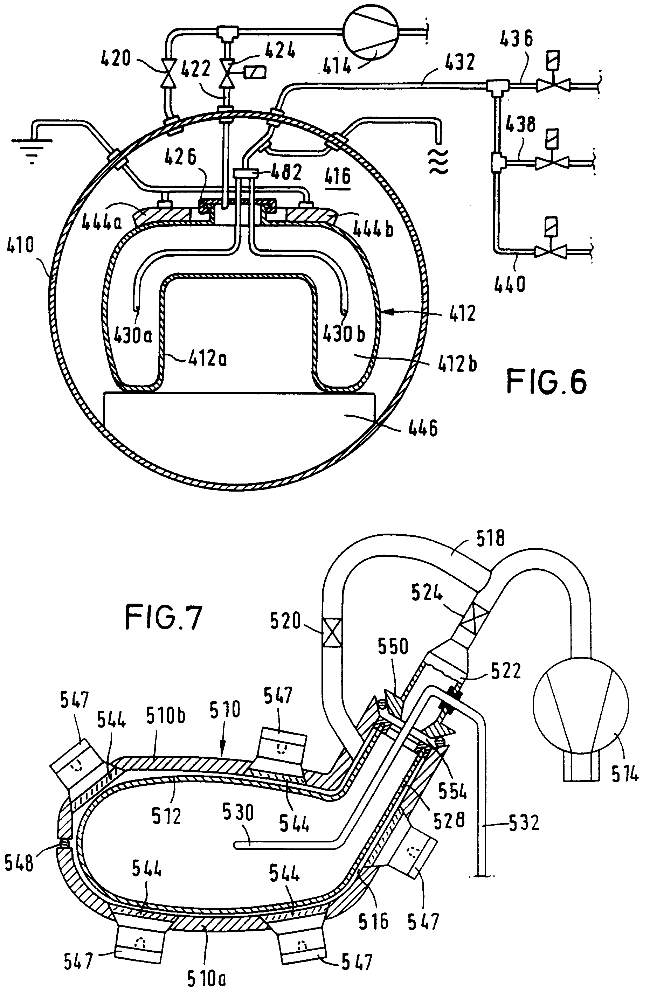

Fig. 5 zeigt einige Einzelheiten einer möglichen Ausgestaltung der Absaugleitung für den Tank und die in den Tank einzuführende Sonde mit weiteren Teilen und Einrichtungen. Im folgenden werden dazu die Bezugszeichen des Ausführungsbeispiels gemäß Fig. 3 verwendet, wenngleich die in Fig. 5 dargestellte Anordnung auch mit geringfügigen Änderungen bei den anderen Ausführungsbeispielen verwendet werden kann. Die Zuleitung 232 wird durch die Wandung des Saugrohres 222 in dieses eingeführt. Es erstreckt sich nach einer rechtwinkligen Abbiegung im wesentlichen koaxial durch das Saugrohr 222 hindurch in Richtung auf den Tank, in den hinein es sich als Sonde 230 fortsetzt. Die Sonde ist mit Bohrungen 270 für den Austritt der gas- bzw. dampfförmigen Ausgangssubstanz(en) versehen. Ferner ist eine Lichtleitfaser 272 vorgesehen, die im wesentlichen parallel zur Leitung 232 verläuft und etwa am Übergang von dieser zur Sonde 230 endet, so daß in der Betriebslage der Teile eine Beobachtung des Plasmas im Tank möglich ist. An diesem Ende ist die Lichtleitfaser 272 durch ein Fenster 274 verschlossen, durch welches die Beobachtung des im Tank 212 gezündeten Plasmas erfolgt. Dem Fenster 274 ist eine Widerstandsheizung 276 zugeordnet, durch die das Fenster 274 auf eine Temperatur erwärmt wird, die das Absetzen einer Deckschicht auf diesem Fenster verhindert, so daß es durchsichtig bleibt. Die elektrischen Zuleitungen für die Heizung 276 sind mit 278 bezeichnet.

Im Falle der Ausführungsform gemäß den Figuren 1 und 2 würde das Saugrohr am Schnellverschluß 26 bzw. 126 enden können, während die Zuleitung 232 für die Ausgangssubstanz durch eine Durchbrechung in der Kappe oder dergleichen des Schnellverschlusses hindurchgeführt wäre. Letzteres gilt auch für die Lichtleitfaser und die elektrischen Zuleitungen für die dem Fenster zugeordnete Widerstandsheizung.

Abweichend von den in den Figuren 1-4 dargestellten Ausführungsbeispielen besteht auch die Möglichkeit, mehr als eine Sonde innerhalb desselben Hohlkörpers vorzusehen. Dies wird insbesondere dann zweckmäßig sein, wenn der Hohlkörper eine Gestalt aufweist, die es schwierig macht, bei Verwendung lediglich einer Sonde eine gleichmäßige Verteilung der Substanzen für die Bildung der Deckschicht zu erreichen. Eine derartige Ausführungsform ist in Fig. 6 dargestellt, wobei der grundsätzliche Aufbau dieser Ausführungsform mit den der Fig. 2 übereinstimmt, so daß gleiche Teile mit gleichen, jedoch um 300 höheren Bezugszeichen versehen sind. Mit Fig. 1 übereinstimmende Teile sind demzufolge mit um 400 größeren Bezugszeichen versehen.

Der wesentliche Unterschied gemäß der Ausführungsform gemäß Fig. 2 besteht darin, daß aufgrund der im Querschnitt etwa U-förmigen Gestalt des Tankes 412 (Satteltank) zwei Sonden 430a und 430b verwendet werden, die beide zugleich als Elektrode dienen, an welcher eine Wechselspannung von z.B. 125kHz und einer Leistung von z.B. 150 Watt angelegt wird. Die auch verwendete außerhalb des Tankes 412 angeordnete Flächenelektrode ist in zwei Bereiche 444a und 444b derart unterteilt, daß jedem dieser beiden Bereiche eine der beiden Sonden 430a und 430b zuordnet ist. Da der Tank 412 einigermaßen symmetrisch ausgebildet ist, sind auch die beiden Sonden entsprechend angeordnet. Es ist aber durchaus möglich, bei einem unregelmäßig ausgebildeten Tank die Sonden asymmetrisch, entsprechend der jeweiligen Gestalt des Tankes, anzuordnen. Es ist auch eine Ausführungsform denkbar, bei welcher mehr als zwei Sonden vorhanden sind. Entscheidend ist in allen Fällen, die Voraussetzungen dafür zu schaffen, daß über den gesamten Innenraum des Tanks ein möglichst uniformes Plasma entsteht und daß eine möglichst gleichmäßige Verteilung der Substanzen, aus denen die Deckschicht hergestellt wird, gewährleistet ist. Abweichend von der Darstellung gemäß Fig. 6 besteht auch die Möglichkeit, bei Verwendung von mehr als einer Sonde diese Sonden lediglich für die Zuführung der Substanz(en) für die Bildung der Deckschicht zu verwenden und wenigstens eine zweite Elektrode außerhalb des Tanks vorzusehen, wie dies beispielsweise bei der Ausführungsform gemäß Fig.1 der Fall ist.

Bei der Ausführungsform gemäß Fig. 6 sind die beiden Sonden 430a und 430b über ein Verbindungsstück 482 an die Zuleitung 432 angeschlossen. Dabei werden beide Sonden 430a und 430b durch dieselbe Öffnung des Tanks 412, die durch die Kappe 426 verschlossen ist, in den Tank eingeführt. Selbstverständlich ist es auch möglich, die beiden Sonden durch unterschiedliche Öffnungen am Tank in das Innere desselben einzuführen. Dies wird immer dann in Betracht zu ziehen sein, wenn am Tank ohnehin mehr als eine Öffnung vorhanden und der Tank so unregelmäßig ausgebildet ist, daß das Hineinführen der Sonden durch unterschiedliche Öffnungen, die demzufolge auch an unterschiedlichen Stellen in der Tankwandung angebracht sind, eine optimale Anordung der Sonden innerhalb des Tankes erleichtert. Im allgemeinen wird es darauf ankommen, die Sonden jeweils in Bereichen des Innenraumes, die nur durch Zwischenbereiche mit geringen Querschnittsabmessungen miteinander verbunden sind, anzuordnen. Im übrigen besteht auch die Möglichkeit, eine der Sonden lediglich als Elektrode auszubilden. Wie dabei im einzelnen Verfahren wird, hängt von den Umständen des Einzelfalles ab. Im allgemeinen wird eine Zuführung der Ausgangssubstanz(en) durch mehrere Sonden ebenfalls zur Gleichmäßigkeit des Plasmas und damit zur Uniformität der herzustellenden Deckschicht beitragen. Selbstverständlich ist auch bei Vorhandensein von mehr als einer Öffnung am Tank dafür zu sorgen, daß alle Öffnungen verschlossen sind, um die für die Bildung des Plasmas erforderlichen Bedingungen innerhalb des Hohlkörpers schaffen zu können.

Das in Fig. 7 dargestellte Ausführungsbeispiel stimmt in wesentlichen Teilen mit dem gemäß Fig. 3 überein, so daß der Fig. 3 entsprechende Teile auch mit gleichen, jedoch um 300 höheren Bezugszeichen versehen sind. Der wesentliche Unterschied besteht darin, daß beim Ausführungsbeispiel gemäß Fig. 7 das Plasma durch Mikrowellen erzeugt wird, wobei auch hier die Wandung der Vakuumkammer 510 weitgehend an die Gestalt des zu behandelnden Kunststofftanks 512 angepaßt ist. Dadurch wird nicht nur die für die Evakuierung des Innenraums 516 erforderliche Zeit erheblich reduziert. Vielmehr bewirkt diese Ausgestaltung auch eine Optimierung des Einkoppelns der Mikrowellen in das Innere des Tankes 512. Dies führt zu einer merklichen Verkürzung der für das Aufbringen einer Beschichtung mit bestimmter Qualität erforderlichen Behandlungsdauer im Vergleich beispielsweise mit einer Vakuumkammer mit einer Gestaltung gemäß Fig. 1.

Die Wandung der Vakuumkammer 510 ist mit Mikrowellenfenstern 544 aus Quarzglas versehen, über welche die Mikrowellen, die jeweils von einem Mikrowellengenerator 547, der außerhalb der Vakuumkammer 510 angeordnet ist, in letzterer eingekoppelt werden. Abweichend von der in Fig. 7 der Zeichnung dargestellten Ausgestaltung, bei welcher jedem Mikrowellenfenster 544 ein eigener Mikrowellengenerator 547 zugeordnet ist, besteht auch die Möglichkeit, für die Vakuumkammer 510 lediglich einen Mikrowellengenerator zu verwenden, wobei dann über einen geeigneten Verteiler und Leitungen die Mikrowellen zu den einzelnen Mikrowellenfenstern geführt werden. Auch hier können der innerhalb des Tankes 512 angeordneten Sonde 530 für die Zuführung der für die Bildung der polymeren Deckschicht erforderlichen Substanzen und ggf. auch der die Bildung von Staub hemmenden Komponente Einrichtungen für die Überwachung des Plasmas usw. zugeordnet sein.

## Patentansprüche

1. Verfahren zum Herstellen wenigstens einer polymeren Deckschicht auf wenigstens einem Teilbereich der inneren Oberfläche eines wenigstens teilweise aus Kunststoff bestehenden Hohlkörpers unter Anwendung der Niederdruck-Plasmapolymerisation, wobei die Gasatmosphäre, die das mittels hochfrequenter elektromagnetische Energie erzeugte Plasma bildet, eine unter den jeweiligen Plasmabedingungen polymerisierbare und mit ausreichender Geschwindigkeit überwiegend kettenbildende Komponente enthält, dadurch gekennzeichnet, daß die das Plasma bildende Gasatmosphäre eine unter den jeweiligen Plasmabedingungen polymerisierbare überwiegend Verzweigungs- bzw. Vernetzungsstellen bildende Komponente enthält.

2. Verfahren nach Anspruch 1, dadurch gekennzeichnet, daß die das Plasma bildende Gasatmosphäre eine der Bildung von Staub entgegenwirkende Komponente enthält.

3. Verfahren nach Anspruch 2, dadurch gekennzeichnet, daß als der Bildung von Staub entgegenwirkende Komponente inerte Gase oder Dämpfe dem Plasma zugesetzt werden.

4. Verfahren nach Anspruch 2, dadurch gekennzeichnet, daß als der Bildung von Staub entgegenwirkende Komponente solche Substanzen hinzugefügt werden, die im Plasma reaktive Teilchen, z.B. Monoradikale bilden, die die Bildung großer Aggregate in der Gasphase hemmen.

5. Verfahren nach Anspruch 1 oder 2, dadurch gekennzeichnet, daß wenigstens zwei der Komponenten als voneinander verschiedene Gase und/oder Dämpfe in den Hohlkörper eingeführt werden.

6. Verfahren nach Anspruch 1 oder 2, dadurch gekennzeichnet, daß wenigstens zwei der Komponenten als Strukturelemente desselben Moleküls in das Plasma eingeführt werden.

7. Verfahren nach Anspruch 1 und 6, dadurch gekennzeichnet, daß eine überwiegend kettenbildende Substanz in das Plasma eingeführt wird, von der ein Teil im Plasma gespalten und zu einer überwiegend Verzweigungs- und Vernetzungsstellen bildenden Komponente umgewandelt wird.

8. Verfahren nach Anspruch 1, dadurch gekennzeichnet, daß die das Plasma bildende Gasatmosphäre wenigstens eine im wesentlichen unpolare gas- und/oder dampfförmige Ausgangssubstanz enthält.

9. Verfahren nach Anspruch 1, dadurch gekennzeichnet, daß die Vernetzung der die polymere Deckschicht bildenden Substanzen nur in einem Ausmaß durchgeführt wird, bei welchem die Deckschicht noch keine Versprödung erfährt, die zu einem Lösen von der inneren Oberfläche des im wesentlichen elastisch verformbaren Hohlkörpers führen würde.

10. Verfahren nach Anspruch 1, dadurch gekennzeichnet, daß der mit wenigstens einer Deckschicht zu versehene Bereich des Substrates einer Vorbehandlung und/oder Nachbehandlung mit einem nicht beschichtenden Plasma unterzogen wird.

11. Verfahren nach Anspruch 1, dadurch gekennzeichnet, daß das Aufbringen der wenigstens einen Deckschicht auf die innere Oberfläche des Behälters innerhalb einer Vakuumkammer erfolgt.

12. Verfahren nach Anspruch 11, dadurch gekennzeichnet, daß der Druck innerhalb des Hohlkörpers 1 - 150 Pa beträgt.

13. Verfahren nach Anspruch 12, dadurch gekennzeichnet, daß der Druck innerhalb des Hohlkörpers 3 - 20 Pa beträgt.

14. Verfahren nach Anspruch 11, dadurch gekennzeichnet, daß der Druck außerhalb des Hohlkörpers innerhalb der Vakuumkammer so gewählt ist, daß das Entstehen eines Plasmas ausgeschlossen ist.

15. Verfahren nach Anspruch 14, dadurch gekennzeichnet, daß der Druck außerhalb des Hohlkörpers in der Vakuumkammer höher als der Druck innerhalb des Hohlkörpers und so gewählt ist, daß eine unzulässige Verformung des Hohlkörpers unter der Einwirkung des Druckunterschiedes vermieden wird.

16. Verfahren nach Anspruch 15, dadurch gekennzeichnet, daß der Druck in der Vakuumkammer außerhalb des darin befindlichen Hohlkörpers größer als 5 mbar ist.

17. Verfahren nach Anspruch 1, dadurch gekennzeichnet, daß das Plasma innerhalb des Hohlkörpers mit einer Radiofrequenz von 30 kHz - 100 MHz erzeugt wird.

18. Verfahren nach Anspruch 1, dadurch gekennzeichnet, daß die Radiofrequenz-Leistungsdichte 0,25 - 20 W/dm³, vorzugsweise 0,5 - 10 W/dm³ Volumen innerhalb des Hohlkörpers beträgt.

19. Verfahren nach Anspruch 1, dadurch gekennzeichnet, daß zur Erzeugung des Plasmas innerhalb des Hohlkörpers Mikrowellen durch wenigstens ein Fenster in der Wandung der Vakuumkammer in diese und den darin befindlichen Hohlkörper eingekoppelt werden.

20. Verfahren nach Anspruch 19, dadurch gekennzeichnet, daß die Mikrowellen in der Kammer zur Vergleichmäßigung gestreut werden.

21. Verfahren nach Anspruch 19, dadurch gekennzeichnet, daß die Mikrowellen zur Erzeugung des Plasmas innerhalb des Hohlkörpers durch eine Mikrowellen-Stabantenne in die Vakuumkammer eingekoppelt werden.

22. Verfahren nach Anspruch 21, dadurch gekennzeichnet, daß die Mikrowellen zur Erzeugung des Plasmas innerhalb des Hohlkörpers direkt in das Innere des in der Vakuumkammer befindlichen Hohlkörpers eingekoppelt werden.

23. Verfahren nach Anspruch 19, dadurch gekennzeichnet, daß die Mikrowellen zur Erzeugung des Plasmas innerhalb des Hohlkörpers über eine Schlitzantenne in die Vakuumkammer eingekoppelt werden.

24. Verfahren nach Anspruch 19, dadurch gekennzeichnet, daß durch innerhalb und/oder außerhalb des Hohlkörpers angeordnete Magnete das im Hohlkörper durch Mikrowellen erzeugte Plasma beeinflußt wird.

25. Verfahren nach Anspruch 19, dadurch gekennzeichnet, daß die Mikrowellen-Leistungsdichte 0,25 - 50 W/dm³, vorzugsweise 0,5 - 20 W/dm³ Volumen innerhalb des Hohlkörpers beträgt.

26. Verfahren nach Anspruch 17 und 19, dadurch gekennzeichnet, daß das Plasma innerhalb des Hohlkörpers durch gleichzeitige Anwendung sowohl von Radiofrequenz als auch von Mikrowellen erzeugt wird.

27. Verfahren nach Anspruch 1, dadurch gekennzeichnet, daß die Durchflußrate aller wirksamen Komponenten der das Plasma bildenden Gasatmosphäre 5 cm³/min - 1000 cm³/min, vorzugsweise 10 cm³/min - 150 cm³/min beträgt.

28. Verfahren nach Anspruch 1, dadurch gekennzeichnet, daß die überwiegend kettenbildende Komponente aus wenigstens einer unter Plasmabedingungen leicht polymerisierenden Verbindung, z. B. einem Monoollefin Cycloalkan, Nitril, Aromat oder Heteroaromat, vorzugsweise Ethylen, Propen, Buten, Isobuten, Cyclopropan, Pyrrol, Thiophen besteht.

29. Verfahren nach Anspruch 2, dadurch gekennzeichnet, daß die überwiegend vernetzende Komponente aus einer Verbindung mit wenigstens einer C=C-Dreifachbindung, vorzugsweise Acetylen oder mit kumulierten C=C-Doppelbindungen, bevorzugt Allen, besteht.

30. Verfahren nach Anspruch 1, dadurch gekennzeichnet, daß als überwiegend vernetzende Komponente eine hoch ungesättigte Kohlenstoffverbindung, z. B. ein Diolefin, bevorzugt Butadien, oder Isopren, ein Alkenin, z. B. Vinylacetylen, ein Alkenylaromat, insbesondere Styrol, ein Alkinylaromat oder ein Alkenylnitril, z.B. Acrylnitril, verwendet wird.

31. Verfahren nach Anspruch 1, dadurch gekennzeichnet, daß als sowohl kettenbildende als auch vernetzende Komponenten liefernde Substanz ein Siloxan, z.B. Hexamethyldisiloxan, ein Silazan, z.B. Hexamethyldisilazan, oder ein organisch substituiertes Silan, vorzugsweise ein Alkenyl- oder Alkoxylsilan, z.B. Vinyltrimethylsilan, oder Triethoxyvinylsilan verwendet wird.

32. Verfahren nach Anspruch 2, dadurch gekennzeichnet, daß als staubverhindernde Komponente ein Edelgas, vorzugsweise, Argon, verwendet wird.

33. Verfahren nach Anspruch 2, dadurch gekennzeichnet, daß als staubverhindernde Komponente eine Verbindung, die im Plasma Monoradikale bildet, z. B. H₂, N₂, NH₃ oder ein niederes Alkan, vorzugsweise CH₄, verwendet wird.

34. Verfahren nach Anspruch 1, dadurch gekennzeichnet, daß mehrere Hohlkörper gleichzeitig innerhalb einer Vakuumkammer behandelt werden.

## Claims

1. A method of producing at least one polymer cover layer on at least a portion of the inside surface of a hollow body which at least partially comprises plastics material, using low-pressure plasma polymerisation, wherein the gas atmosphere which forms the plasma generated by means of high-frequency electromagnetic energy contains a component which can be polymerised under the respective plasma conditions and which is predominantly chain-forming at adequate speed, characterised in that the gas atmosphere forming the plasma contains a component which can be polymerised under the respective plasma conditions and which predominantly forms branching or cross-linking locations.

2. A method according to claim 1 characterised in that the gas atmosphere forming the plasma contains a component which resists the formation of dust.

3. A method according to claim 2 characterised in that inert gases or vapours are added to the plasma as a component for resisting the formation of dust.

4. A method according to claim 2 characterised in that as the component for resisting the formation of dust such substances are added which in the plasma form reactive particles, for sample monoradials which inhibit the formation of large aggregates in the gaseous phase.

5. A method according to claim 1 or claim 2 characterised in that at least two of the components are introduced into the hollow body in the form of gases and/or vapours which are different from each other.

6. A method according to claim 1 or claim 2 characterised in that at least two of the components are introduced into the plasma in the form of structural elements of the same molecule.

7. A method according to claims 1 and 6 characterised in that a predominantly chain-forming substance is introduced into the plasma, of which substance a part is split up in the plasma and converted to a component predominantly forming branching and cross-linking locations.

8. A method according to claim 1 characterised in that the gas atmosphere forming the plasma contains at least one substantially non-polar starting substance in gas and/or vapour form.

9. A method according to claim 1 characterised in that cross-linking of the substances forming the polymer cover layer is implemented only to an extent at which the cover layer does not yet experience any embrittlement which would result in detachment from the inside surface of the substantially elastically deformable hollow body.

10. A method according to claim 1 characterised in that the region of the substrate which is to be provided with at least one cover layer is subjected to a pre-treatment and/or post-treatment with a non-coating plasma.

11. A method according to claim 1 characterised in that the operation of applying the at least one cover layer to the inside surface of the container is effected within a vacuum chamber.

12. A method according to claim 11 characterised in that the pressure within the hollow body is from 1 to 150 Pa.

13. A method according to claim 12 characterised in that the pressure within the hollow body is from 3 to 20 Pa.

14. A method according to claim 11 characterised in that the pressure outside the hollow body within the vacuum chamber is so selected that the production of a plasma is prevented.

15. A method according to claim 14 characterised in that the pressure outside the hollow body in the vacuum chamber is higher than the pressure within the hollow body and is so selected as to avoid unacceptable deformation of the hollow body under the effect of the pressure difference.

16. A method according to claim 15 characterised in that the pressure in the vacuum chamber outside the hollow body disposed therein is greater than 5 mbar.

17. A method according to claim 1 characterised in that the plasma within the hollow body is generated at a radio frequency of from 30 kHz to 100 MHz.

18. A method according to claim 1 characterised in that the radio frequency power density is from 0.25 to 20 W/dm³, preferably from 0.5 to 10 W/dm³ volume within the hollow body.

19. A method according to claim 1 characterised in that for generation of the plasma within the hollow body microwaves are coupled through at least one window in the wall of the vacuum chamber into same and the hollow body disposed therein.

20. A method according to claim 19 characterised in that the microwaves are scattered in the chamber to make them uniform.

21. A method according to claim 19 characterised in that the microwaves for generating the plasma within the hollow body are coupled into the vacuum chamber by a microwave bar antenna.

22. A method according to claim 21 characterised in that the microwave for generating the plasma within the hollow body are coupled directly into the interior of the hollow body which is disposed in the vacuum chamber.

23. A method according to claim 19 characterised in that the microwave for generating the plasma within the hollow body are coupled into the vacuum chamber by way of a slot antenna.

24. A method according to claim 19 characterised in that the plasma generated by microwaves in the hollow body is influenced by magnets arranged within and/or outside the hollow body.

25. A method according to claim 19 characterised in that the microwave power density is from 0.25 to 50 W/dm³, preferably from 0.5 to 20 W/dm³ volume within the hollow body.

26. A method according to claim 17 and claim 19 characterised in that the plasma within the hollow body is generated by the simultaneous use both of radio frequency and also microwaves.

27. A method according to claim 1 characterised in that the through-flow rate of all effective components of the gas atmosphere forming the plasma is from 5 cm³/min to 1000 cm³/min, preferably from 10 cm³/min to 150 cm³/min.

28. A method according to claim 1 characterised in that the predominantly chain-forming component comprises at least one compound which polymerises easily under plasma conditions, for example a monoolefin, cycloalkane, nitrile, aromatic or heteroaromatic, preferably ethylene, propene, butene, isobutene, cyclopropane, pyrrole and thiophen.

29. A method according to claim 2 characterised in that the predominantly cross-linking component comprises a compound with at least one C=C-triple bond, preferably acetylene, or with accumulated C=C-double bonds, preferably allene.

30. A method according to claim 1 characterised in that the predominantly cross-linking component used is a highly unsaturated carbon compound, for example a diolefin, preferably butadiene or isoprene, an alkenine, for example vinyl acetylene, an alkenyl aromatic, in particular styrene, an alkinyl aromatic or an alkenyl nitrile, for example acrylonitrile.

31. A method according to claim 1 characterised in that the substance used for providing both chain-forming and also cross-linking components is a siloxane, for example hexamethyldisiloxane, a silazane, for example hexamethyldisilazane, or an organically substituted silane, preferably an alkenyl or alkoxyl silane, for example vinyltrimethylsilane, or triethoxyvinylsilane.

32. A method according to claim 2 characterised in that an inert gas, preferably argon, is used as the dust-preventing component.

33. A method according to claim 2 characterised in that a compound which forms monoradicals in the plasma, for example H₂, N₂, NH₃ or a low alkane preferably CH₄, is used as the dust-preventing component.

34. A method according to claim 1 characterised in that a plurality of hollow bodies are simultaneously treated within a vacuum chamber.

## Revendications

1. Procédé pour réaliser au moins une couche protectrice en matière polymère sur au moins une zone partielle de la face interne d'un corps creux confectionné au moins en partie en matière plastique, en opérant par polymérisation sous l'effet d'un plasma à basse pression, l'atmosphère gazeuse où le plasma est produit par diffusion d'énergie électromagnétique à haute fréquence contenant un composant capable de se polymériser dans les conditions particulières de chaque plasma pour former des liaisons en chaîne de manière prépondérante et à une vitesse suffisante, *caractérisé* en ce que l'atmosphère gazeuse où est produit le plasma contient un composant capable de se polymériser dans les conditions du plasma considéré, grâce aux points de ramification et de réticulation qui apparaissent alors de manière prépondérante dans ce composant.

2. Procédé selon la revendication 1, *caractérisé* en ce que l'atmosphère gazeuse où le plasma est produit contient un composant qui s'oppose à la formation de poussières.

3. Procédé selon la revendication 2, *caractérisé* en ce qu'on ajoute au plasma des composants constitués par des gaz ou vapeurs inertes, propres à s'opposer à la formation de poussières.

4. Procédé selon la revendication 2, *caractérisé* en ce que les composants ajoutés pour s'opposer à la formation de poussières sont constitués par des substances qui donnent naissance dans le plasma à des particules réactives - telles que des monoradicaux par exemple - qui empêchent la formation de gros agrégats dans la phase gazeuse.

5. Procédé selon la revendication 1 ou 2, *caractérisé* en ce qu'on introduit dans le corps creux au moins deux composants constitués par des gaz et/ou des vapeurs qui diffèrent entre eux.

6. Procédé selon la revendication 1 ou 2, *caractérisé* en ce qu'au moins deux des composants introduits dans le plasma sont des éléments structuraux de la même molécule.

7. Procédé selon les revendications 1 et 6, *caractérisé* en ce qu'on introduit dans le plasma une substance capable de former des liaisons en chaîne d'une manière prépondérante, une partie de cette substance subissant dans le plasma une fission, pour être transformée en un composant où apparaissent de manière prépondérante des points de ramification et de réticulation.

8. Procédé selon la revendication 1, *caractérisé* en ce que l'atmosphère gazeuse où est produit le plasma contient au moins une substance de départ sensiblement homopolaire, constituée par un gaz et/ou une vapeur.

9. Procédé selon la revendication 1, *caractérisé* en ce qu'on assure la réticulation des substances constituant la couche protectrice en matière polymère en arrêtant l'opération avant que n'apparaisse dans cette couche protectrice tout signe de fragilité, susceptible de provoquer un décollement pouvant séparer cette couche de la face interne du corps creux qui est dans l'ensemble élastiquement déformable.

10. Procédé selon la revendication 1, *caractérisé* en ce qu'on fait subir à la zone du substrat prévue pour recevoir au moins une couche de protection, un traitement effectué au préalable et/ou après coup au moyen d'un plasma qui ne produit pas de couche.

11. Procédé selon la revendication 1, *caractérisé* en ce qu'on opère à l'intérieur d'une enceinte sous vide, pour traiter la face interne du réservoir en y déposant au moins une couche de protection.

12. Procédé selon la revendication 11, *caractérisé* en ce que la pression à l'intérieur du corps creux est comprise entre 1 et 150 Pa.

13. Procédé selon la revendication 12, *caractérisé* en ce que la pression à l'intérieur du corps creux est comprise entre 3 et 20 Pa.

14. Procédé selon la revendication 11, *caractérisé* en ce qu'on choisit la valeur de la pression de l'enceinte sous vide à l'extérieur du corps creux pour y empêcher la formation d'un plasma.

15. Procédé selon la revendication 14, *caractérisé* en ce que la pression de l'enceinte sous vide à l'extérieur du corps creux est supérieure à la pression à l'intérieur du corps creux, et en ce qu'on en a choisi la valeur pour éviter une déformation inacceptable du corps creux sous l'effet de la différence de pression.

16. Procédé selon la revendication 15, *caractérisé* en ce que la pression de l'enceinte sous vide, à l'extérieur du corps creux en place dans cette enceinte, est supérieure à 5 mbar.

17. Procédé selon la revendication 1, *caractérisé* en ce qu'on produit le plasma à l'intérieur du corps creux en opérant à une fréquence radio comprise entre 30 kHz et 100 MHz.

18. Procédé selon la revendication 1, *caractérisé* en ce que le taux de puissance à fréquence radio à l'intérieur du corps creux est compris entre 0,25 et 20 W/dm³, et compris de préférence entre 0,5 et 10 W/dm³.

19. Procédé selon la revendication 1, *caractérisé* en ce que pour produire le plasma à l'intérieur du corps creux, on fait intervenir des micro-ondes, diffusées à travers au moins une fenêtre pratiquée dans la paroi de l'enceinte sous vide, pour pénétrer dans cette enceinte et dans le corps creux qui s'y trouve.

20. Procédé selon la revendication 19, *caractérisé* en ce qu'on assure la dispersion des micro-ondes dans l'enceinte sous vide pour en égaliser l'effet.

21. Procédé selon la revendication 19, *caractérisé* en ce qu'on diffuse les micro-ondes dans l'enceinte sous vide au moyen d'une antenne en forme de bâtonnet pour y produire le plasma.

22. Procédé selon la revendication 21, *caractérisé* en ce que, pour produire le plasma à l'intérieur du corps creux, on diffuse les micro-ondes directement à l'intérieur du corps creux qui se trouve dans l'enceinte sous vide.

23. Procédé selon la revendication 19, *caractérisé* en ce que, pour produire le plasma à l'intérieur du corps creux, on fait pénétrer les micro-ondes dans l'enceinte sous vide par une antenne fendue.

24. Procédé selon la revendication 19, *caractérisé* en ce qu'on agit sur le plasma produit dans le corps creux par des micro-ondes, au moyen d'amants disposés à l'intérieur et/ou à l'extérieur du corps creux.

25. Procédé selon la revendication 19, *caractérisé* en ce que le taux de puissance des micro-ondes à l'intérieur du corps creux est compris entre 0,25 et 50 W/dm³, et compris de préférence entre 0,5 et 20 W/dm³.

26. Procédé selon les revendications 17 et 19, *caractérisé* en ce qu'on produit le plasma à l'intérieur du corps creux en y faisant agir simultanément une fréquence radio et des micro-ondes.

27. Procédé selon la revendication 1, *caractérisé* en ce que le débit volumétrique de tous les composants actifs de l'atmosphère gazeuse où est produit le plasma est compris entre 5 cm³/min. et 1000 cm³/min., et compris de préférence entre 10 cm³/min. et 150 cm³/min.

28. Procédé selon la revendication 1, *caractérisé* en ce que le composant capable de former les liaisons en chaîne d'une manière prépondérante est à base d'au moins un produit composé qui se polymérise facilement sous l'effet d'un plasma, comme par exemple une mono-oléfine, un cycloalkane, un nitrile, un composé aromatique ou hétéroaromatique, tels que de préférence l'éthylène, le propane, le butane, l'isobutane, le cyclopropane, le pyrrole, le thiophène.

29. Procédé selon la revendication 2, *caractérisé* en ce que le composant capable de se réticuler d'une manière prépondérante est à base d'un produit composé qui présente au moins une triple liaison C = C, comme l'acétylène de préférence, ou à base d'un produit composé qui présente plusieurs liaisons C = C doubles, comme le propadiène de préférence.

30. Procédé selon la revendication 1, *caractérisé* en ce que le composant capable de se réticuler d'une manière prépondérante que l'on utilise est constitué par un hydrocarbure non saturé d'ordre élevé, tel qu'une dioléfine - de préférence le butadiène ou l'isoprène - ou par un hydrocarbure éthylènique tel que par exemple le vinylacétylène, ou par un composé aromatique d'alcène, en particulier le styrol, ou encore par un composé aromatique ou un nitrile d'hydrocarbure éthylénique tel que l'acrylonitrile par exemple.

31. Procédé selon la revendication 1, *caractérisé* en ce qu'on emploie un composant capable de former des liaisons en chaîne et de se réticuler tel qu'un siloxane, comme par exemple l'hexaméthyldisiloxane, ou un silazane comme par exemple l'hexaméthyldisilazane, ou encore un silane à substitution organique, comme de préférence un alkényl - ou alkoxylsilane, par exemple le vinyltriméthylsilane ou le triéthoxyvinylsilane.

32. Procédé selon la revendication 2, *caractérisé* en ce qu'on utilise un composant antipoussière constitué par un gaz rare, tel que l'argon de préférence.

33. Procédé selon la revendication 2, *caractérisé* en ce qu'on utilise un composant antipoussière constitué par un produit composé donnant naissance dans le plasma à des monoradicaux tels que H₂, N₂, NH₃ par exemple, ou un alcane inférieur, tel que CH₄ de préférence.

34. Procédé selon la revendication 1, *caractérisé* en ce qu'on traite simultanément plusieurs corps creux dans une même enceinte sous vide.
